# EUROPÄISCHE PATENTANMELDUNG

(11) **EP 2 853 929 A1**
(43) Veröffentlichungstag der Anmeldung: **01.04.2015**
(21) Anmeldenummer: 13186702.0
(22) Anmeldetag: 30.09.2013
(51) Int. Cl.: G01V 8/20

(54) **Optoelektronischer Sicherheitssensor**

(71) Anmelder: SICK AG, 79183 Waldkirch/Breisgau (DE)
(72) Erfinder: Haberer, Manfred, 79359 Riegel (DE); Schieber, Andreas, 79211 Denzlingen (DE); Haberstroh, Frank, 79183 Waldkirch (DE)
(74) Vertreter: Manitz, Finsterwald & Partner GbR

(57) **Zusammenfassung**

Die Erfindung betrifft einen optoelektronischen Sicherheitssensor umfassend eine optoelektronische Messeinrichtung zum Erzeugen von Messsignalen, die von einem Zustand eines von dem Sicherheitssensor beobachteten Sicherheitsbereichs abhängen, und eine elektronische Auswerteeinheit zur Auswertung der Messsignale. Die elektronische Auswerteeinheit umfasst eine in den optoelektronischen Sicherheitssensor integrierte speicherprogrammierbare Steuerung zur logischen Auswertung von logischen Zustandsgrößen, die aus den Messsignalen abgeleitet sind.

## Beschreibung

Die Erfindung betrifft einen optoelektronischen Sicherheitssensor, vorzugsweise einen Laserscanner, ein Lichtgitter oder eine Kamera.

Bekannte optoelektronische Sicherheitssensoren umfassen eine optoelektronische Messeinrichtung zum Erzeugen von Messsignalen, die von einem Zustand eines von dem Sicherheitssensor beobachteten Sicherheitsbereichs abhängen, und eine elektronische Auswerteeinheit zur Auswertung der Messsignale. Derartige optoelektronische Sicherheitssensoren werden zum Beispiel in industriellen Fertigungsanlagen zur Absicherung von Gefahrstellen verwendet. Beispielsweise kann ein Laserscanner oder ein Lichtgitter überwachen, ob in einem Gefahrbereich einer Maschine, beispielsweise in der Nähe einer Presse, ein gefährdetes Objekt, wie zum Beispiel die Hand eines Bedieners, vorhanden ist. In diesem Fall kann eine Sicherheitsabschaltung der Presse erforderlich sein, um eine gefahrbringende Bewegung der Presse anzuhalten. Eine sichere Steuerung einer Anlage mit Hilfe eines Sicherheitssensors kann auch das Steuern von aktiven Prozessschritten abhängig von in einem Sicherheitsbereich vorhandenen Objekten umfassen.

In der Praxis kann es sinnvoll sein, die von dem optoelektronischen Sicherheitssensor gelieferte Information, z.B. eine Sicherheitsinformation, die aussagt, ob in dem beobachteten Sicherheitsbereich ein eine Gefahr bedeutendes Objekt vorhanden ist oder nicht, mit weiteren Informationen wie zum Beispiel Sicherheitsinformationen anderer Schutzgeräte logisch zu verknüpfen, bevor eine Steuerentscheidung z.B. über die Abschaltung einer Maschine getroffen wird.

Ein Sicherheitssystem zur Absicherung einer industriellen Fertigungsanlage umfasst deshalb neben dem optoelektronischen Sicherheitssensor eine Sicherheitssteuerung, welche mit dem optoelektronischen Sicherheitssensor und gegebenenfalls weiteren Schutzgeräten oder anderen Komponenten kommunikativ verbunden ist, um Informationen auszutauschen, die in der Sicherheitssteuerung zur Festlegung der Steuerentscheidung logisch miteinander verknüpft werden.

In der Sicherheitssteuerung kann auch eine Auswahllogik realisiert sein, welche abhängig von den verfügbaren Informationen eine Entscheidung über ein von dem optoelektronischen Sicherheitssensor zu beobachtendes Schutzfeld trifft. Abhängig von dieser Auswahl kann die Sicherheitssteuerung ein binär codiertes Signal erzeugen und an den optoelektronischen Sicherheitssensor übermitteln, so dass der Sicherheitssensor das entsprechende Schutzfeld beobachtet.

Die Realisierung eines funktionsfähigen Sicherheitssystems in der vorstehend beschriebenen Weise ist mit einem sehr hohen Aufwand verbunden. Zur Implementierung des Sicherheitssystems müssen eine Vielzahl von Komponenten beschafft und in einer bestimmten Weise konfiguriert und miteinander verkabelt werden. Die Projektierung des Sicherheitssystems ist aufgrund der Vielzahl von beteiligten Komponenten und der notwendigen Konfigurationen und Verkabelungen komplex und fehleranfällig.

Die Ansprechzeit des Sicherheitssystems wird durch die sich bei der Verkabelung des Sicherheitssensors und weiterer Komponenten mit der Sicherheitssteuerung ergebenden Leitungslängen und Signallaufzeiten erhöht, was größere Sicherheitsabstände bzw. Schutzfelder erforderlich macht.

Aufgabe der Erfindung ist es daher, einen optoelektronischen Sicherheitssensor anzugeben, mit dem mit geringerem Aufwand und geringerer Fehleranfälligkeit ein funktionsfähiges Sicherheitssystem mit einer geringen Ansprechzeit geschaffen werden kann, sowie die Angabe eines entsprechenden Sicherheitssystems.

Die Aufgabe wird durch einen optoelektronischen Sicherheitssensor mit den Merkmalen des Anspruchs 1 gelöst.

Der optoelektronische Sicherheitssensor, der in bevorzugten Ausführungsformen ein Laserscanner, ein Lichtgitter oder eine Kamera ist, umfasst eine optoelektronische Messeinrichtung zum Erzeugen von Messsignalen, die von einem Zustand eines von dem Sicherheitssensor beobachteten Sicherheitsbereichs abhängen, und eine elektronische Auswerteeinheit zur Auswertung der Messsignale. Die elektronische Auswerteeinheit umfasst eine in den optoelektronischen Sicherheitssensor integrierte speicherprogrammierbare Steuerung zur logischen Auswertung von logischen Zustandsgrößen, die aus den Messsignalen abgeleitet sind.

Im Rahmen der Erfindung wurde erkannt, dass sich in einen optoelektronischen Sicherheitssensor mit verhältnismäßig geringem Aufwand eine speicherprogrammierbare Steuerung integrieren lässt, die zur Auswertung von logischen Zustandsgrößen eingerichtet ist, die aus den Messsignalen der optoelektronischen Messeinrichtung abgeleitet sind und hier auch als logische Zustandsgrößen "der Messeinrichtung" bezeichnet werden. Die speicherprogrammierbare Steuerung kann dabei mit geringem Aufwand unter Verwendung der in dem optoelektronischen Sicherheitssensor bereits vorhandenen Hardwareinfrastruktur implementiert werden. Indem die integrierte speicherprogrammierbare Steuerung die Aufgaben einer herkömmlichen Sicherheitssteuerung und ggf. weitere Aufgaben übernimmt, lässt sich mit dem erfindungsgemäßen optoelektronischen Sicherheitssensor ein funktionsfähiges Sicherheitssystem ohne eine separate Sicherheitssteuerung realisieren, wodurch der für die Realisierung des Sicherheitssystems erforderliche Aufwand erheblich reduziert wird.

Da die speicherprogrammierbare Steuerung mit "an Bord" des Sicherheitssensors ist und die aus den Messsignalen abgeleiteten Zustandsgrößen in dem optoelektronischen Sicherheitssensor unmittelbar verfügbar sind, werden die mit der Verkabelung des optoelektronischen Sicherheitssensors mit einer separaten Sicherheitssteuerung einhergehenden Signallaufzeiten und Verzögerungen vermieden. Stattdessen übernimmt der Sicherheitssensor Steuerungsaufgaben bzw. die Erzeugung von entsprechenden Steuersignalen selbst, wodurch die Ansprechzeit des Sicherheitssystems verringert wird.

Vorteilhafte Ausführungsformen der Erfindung sind in den Unteransprüchen, der Beschreibung und in den Figuren beschrieben.

Gemäß einer vorteilhaften Ausführungsform ist die speicherprogrammierbare Steuerung eine speicherprogrammierbare Steuerung "in Software". Eine speicherprogrammierbare Steuerung in Software, welche auch als Soft-SPS bezeichnet wird, lässt sich mit besonders geringem Aufwand in einen optoelektronischen Sicherheitssensor integrieren, ohne dass ein übermäßiger zusätzlicher Hardwareaufwand oder eine übermäßige Vergrößerung des zur Realisierung des Sicherheitssensors notwendigen Bauraums resultiert. Die speicherprogrammierbare Steuerung kann zumindest teilweise und vorzugsweise vollständig durch vorhandene Hardwarekomponenten gebildet sein, die programmtechnisch zur Realisierung der speicherprogrammierbaren Steuerung eingerichtet sind. Die Soft-SPS kann z.B. dadurch bereitgestellt werden, dass die vorhandene Hardware mit einem entsprechenden, auf der Hardware auszuführenden Software-Modul konfiguriert wird.

Die Auswerteeinheit kann ein Applikationsmodul umfassen, welches dazu eingerichtet ist, aus den Messsignalen oder davon abgeleiteten Messgrößen die logischen Zustandsgrößen zu erzeugen. Die logischen Zustandsgrößen können eine Information über einen Zustand des beobachteten Sicherheitsbereichs enthalten, insbesondere Informationen über in dem Sicherheitsbereich vorhandene Objekte, d.h. z.B. über das Vorhandensein, die Position und/oder Eigenschaften von Objekten in dem Sicherheitsbereich.

Die logischen Zustandsgrößen können einen sicheren oder nicht sicheren Zustand des beobachteten Sicherheitsbereichs repräsentieren. Die Begriffe "sicher" und "nicht sicher" beziehen sich in diesem Zusammenhang vorzugsweise darauf, ob in dem beobachteten Sicherheitsbereich ein Objekt vorhanden ist, welches möglicherweise eine Personengefährdung während des Betriebs der beobachteten Anlage bzw. einer Maschine der Anlage bedeutet, wie zum Beispiel ein Körperteil eines Bedieners, oder nicht.

Die optoelektronische Messeinrichtung ist vorzugsweise dazu eingerichtet, aus dem Sicherheitsbereich auf die Messeinrichtung treffende elektromagnetische Strahlung zu empfangen und daraus elektrische Empfangssignale zu erzeugen, welche zum Beispiel von der Intensität der zurückkehrenden Strahlung abhängen. Die Auswerteeinheit kann die Empfangssignale verarbeiten, um aus den Empfangssignalen Informationen über in dem Sicherheitsbereich vorhandene Objekte abzuleiten.

Die optoelektronische Messeinrichtung kann zum Beispiel durch einen optoelektronischen Kamerasensor gebildet sein, welcher vorzugsweise dazu ausgebildet ist, ortsaufgelöste Bilder des Sicherheitsbereichs zu erzeugen.

Die optoelektronische Messeinrichtung kann auch dazu eingerichtet sein, elektromagnetische Strahlung in den Sicherheitsbereich auszusenden und die ausgesendete Strahlung zu empfangen, wenn diese aus dem Sicherheitsbereich zurückkehrt. Durch Auswerten der entsprechenden Empfangssignale kann die Auswerteeinheit eine Information darüber ableiten, ob der durch den Sicherheitsbereich verlaufende Lichtweg der jeweiligen ausgesendeten Strahlung frei ist oder durch ein Objekt unterbrochen ist. Im Folgenden wird der Begriff "Licht" allgemein für elektromagnetische Strahlung unterschiedlicher Wellenlänge, also z.B. sichtbare, infrarote oder ultraviolette Strahlung, verwendet.

Die optoelektronische Messeinrichtung ist vorzugsweise dazu ausgebildet, den Sicherheitsbereich örtlich und/oder zeitlich abzutasten. Zur zeitlichen Abtastung wird aus Strahlung, die zu unterschiedlichen Zeitpunkten empfangen wird, jeweils wenigstens ein Empfangssignal erzeugt und ausgewertet. Zur örtlichen Abtastung kann Strahlung auf unterschiedlichen Lichtwegen in den Sicherheitsbereich ausgestrahlt werden und es kann zu den verschiedenen Lichtwegen jeweils ein Empfangssignal erzeugt und ausgewertet werden.

Bei einem Laserscanner wird beispielsweise die Strahlung in unterschiedlichen aufeinanderfolgenden Richtungen in den Sicherheitsbereich ausgesendet. Bei einem Lichtgitter sind mehrere Paarungen aus jeweils einem Sender und einem Empfänger vorgesehen, welche unterschiedliche Lichtwege durch den Sicherheitsbereich realisieren. Eine örtliche Abtastung bzw. Auflösung des Sicherheitsbereichs kann auch durch verschiedene Sensorelemente eines Kamerasensors erreicht werden.

Die Auswerteeinheit und insbesondere das Applikationsmodul ist vorzugsweise dazu eingerichtet, aus den im Rahmen der örtlichen und/oder zeitlichen Abtastung bzw. Auflösung erzeugten Empfangssignalen ein örtlich und/oder zeitlich aufgelöstes Bild des Sicherheitsbereichs zu erzeugen und daraus die Information über in dem Sicherheitsbereich vorhandene Objekte bzw. den sicheren oder nicht sicheren Zustand des Sicherheitsbereichs abzuleiten.

Das Applikationsmodul kann wie nachfolgend genauer erläutert dazu eingerichtet sein, den Sicherheitsbereich gemäß einem vorgegebenen und insbesondere einstellbaren Schutzfeld zu überwachen. Das Schutzfeld ist vorzugsweise durch einen vorgebbaren Teil des von der Messeinrichtung maximal beobachtbaren Sicherheitsbereichs gebildet. Vorzugsweise ist das Applikationsmodul dazu ausgebildet, logische Zustandsgrößen zu erzeugen, die von dem Vorhandensein, der Position und/oder Eigenschaften von in dem Schutzfeld vorhandenen Objekten abhängen. Dazu kann das Applikationsmodul selektiv die dem jeweiligen Teil des Sicherheitsbereichs zugehörigen Empfangssignale auswerten und/oder das Applikationsmodul kann die Messeinrichtung so ansteuern, dass die Erzeugung der Empfangssignale durch die Messeinrichtung an das jeweilige Schutzfeld angepasst ist. Das Schutzfeld kann z.B. aus einem Teil des Sicherheitsbereichs bestehen, in dem während des ordnungsgemäßen Betriebs der Maschine kein Objekt erwartet wird, so dass ein Vorhandensein eines Objekts in diesem Teil des Sicherheitsbereichs einen nicht sicheren Zustand anzeigt. Gemäß einer vorteilhaften Ausführungsform sind die speicherprogrammierbare Steuerung und das Applikationsmodul zumindest teilweise und vorzugsweise vollständig durch eine gemeinsame Verarbeitungseinheit gebildet. Die speicherprogrammierbare Steuerung ist dabei vorzugsweise eine Soft-SPS. Durch eine gemeinsame Verarbeitungseinheit, die programmtechnisch eingerichtet ist, um die speicherprogrammierbare Steuerung und das Applikationsmodul zumindest teilweise oder vollständig zu realisieren, wird der Aufwand für die Bereitstellung des Sicherheitssensors gering gehalten. Die gemeinsame Verarbeitungseinheit umfasst vorzugsweise eine digitale Signalverarbeitungseinheit und kann zum Beispiel einen gemeinsamen Mikroprozessor umfassen, welcher die speicherprogrammierbare Steuerung und das Applikationsmodul zumindest teilweise und vorzugsweise vollständig realisiert.

Die Auswerteeinheit ist bevorzugt dazu eingerichtet, abhängig von einer Sicherheitsauswertung, die eine durch die speicherprogrammierbare Steuerung durchgeführte logische Auswertung umfasst, eine Steuermaßnahme zu ergreifen, insbesondere zur Steuerung einer durch den Sicherheitssensor beobachteten Anlage bzw. zumindest eines Aktors der Anlage, welcher z.B. ein sicherer Antrieb sein kann. Die Steuermaßnahme umfasst bevorzugt das Erzeugen eines Steuersignals durch die Auswerteeinheit und der Sicherheitssensor kann einen Signalausgang zur Ausgabe des Steuersignals umfassen. Die der Steuermaßnahme zugrunde liegende Sicherheitsauswertung umfasst vorzugsweise die logische Auswertung der von den Messsignalen der Messeinrichtung abgeleiteten logischen Zustandsgrößen und kann alternativ oder zusätzlich die logische Auswertung weiterer logischer Zustandsgrößen umfassen, die aus den Informationssignalen von weiteren internen oder externen Komponenten ableitbar sind, wie nachfolgend im Einzelnen beschrieben ist. Durch die von der Sicherheitsauswertung abhängige Steuermaßnahme wird vorzugsweise eine sichere Steuerung der beobachteten Anlage bzw. des Aktors erreicht. Die vorstehend beschrieben, auf der Sicherheitsauswertung basierende Funktion des Sicherheitssensors wird auch als Steuer- oder Sicherheitsfunktion bezeichnet.

Durch die logische Auswertung und die davon abhängige Steuermaßnahme kann in einem Sicherheitssystem eine aktive Steuerung der von dem Sicherheitssensor beobachteten Anlage erfolgen. Das bedeutet, dass die Anlage oder der zumindest eine Aktor der Anlage durch den Sicherheitssensor zur Durchführung von aktiven Prozessschritten angesteuert wird. Ein von dem Sicherheitssensor angesteuerter Aktor kann z.B. einen, insbesondere sicheren, Antrieb, ein Bearbeitungsgerät, ein Fördergerät oder einen ähnlichen Aktor umfassen, dessen Aktionen für die Durchführung des jeweiligen Prozesses, z.B. eines industriellen Fertigungsprozesses, notwendig sind. Bei der beobachteten Anlage kann es sich um eine industrielle Fertigungsanlage handeln.

Zum Zweck der aktiven Steuerung kann, beispielsweise wenn der Sicherheitssensor ein bestimmtes Objekt oder einen bestimmten Vorgang in dem Sicherheitsbereich detektiert, diese Information durch die speicherprogrammierbare Steuerung verarbeitet und insbesondere mit logischen Zustandsgrößen von weiteren Komponenten verknüpft werden und daraufhin ein Aktor angesteuert werden, z.B. um eine Aktion eines Bearbeitungsgeräts oder eine sonstige für den Prozess notwendige Aktion wie z.B. ein Bewegen eines Objekts von A nach B auszulösen.

Alternativ oder zusätzlich zu einer aktiven Steuerung kann durch die logische Auswertung und die davon abhängige Steuermaßnahme eine Sicherheitsabschaltung der von dem Sicherheitssensor beobachteten Anlage auslösbar sein, d.h. dass ein von der Anlage durchgeführter Prozess abhängig von der durchgeführten Auswertung angehalten werden kann. Die Sicherheitsabschaltung kann z.B. veranlasst werden, wenn durch den Sicherheitssensor ein Objekt in dem Sicherheitsbereich detektiert wird, welches eine Gefährdung bedeutet, bzw. ein nicht sicherer Zustand des Sicherheitssensors vorliegt. In diesem Fall kann z.B. ein mit einem Steuersignal des Sicherheitssensors ansteuerbares und insbesondere in der Stromversorgung der Maschine zwischengeschaltetes Sicherheitsrelais als Aktor vorgesehen sein und/oder es kann wenigstens ein OSSD-Ausgang (OSSD = Output Signal Switching Device) zur Ausgabe des Steuersignals vorgesehen sein. Der OSSD-Ausgang kann zum Beispiel mit einem externen Sicherheitsrelais verbindbar sein, um das externe Sicherheitsrelais mit dem vorzugsweise als OSSD-Signal ausgebildeten Steuersignal anzusteuern.

Da die speicherprogrammierbare Steuerung in den Sicherheitssensor integriert ist, ist zur Realisierung der beschriebenen Steuer- oder Sicherheitsfunktion in einem Sicherheitssystem keine separate Sicherheitssteuerung oder eine Verkabelung mit einer solchen Sicherheitssteuerung notwendig. Stattdessen kann in dem Sicherheitssystem der Sicherheitssensor bzw. dessen Auswerteeinheit, insbesondere über den vorstehend beschriebenen Signalausgang, unmittelbar mit der zu steuernden Anlage bzw. dem zumindest einen zu steuernden Aktor verbunden sein und insbesondere direkt mit diesem kommunizieren. Zum Beispiel kann der Signalausgang direkt an einen sicheren Antrieb angeschlossen sein, um den sicheren Antrieb zu steuern.

Gemäß einer vorteilhaften Ausführungsform ist die Auswerteeinheit dazu eingerichtet, Informationssignale von wenigstens einer weiteren Komponente zu empfangen und auszuwerten. Die Auswertung umfasst vorzugsweise eine logische Auswertung von logischen Zustandsgrößen, die aus den Informationssignalen abgeleitet sind, durch die speicherprogrammierbare Steuerung. Die logische Auswertung ist vorzugsweise Teil einer Sicherheitsauswertung gemäß der vorstehenden Beschreibung, d.h. die logische Auswertung dient bevorzugt der Steuerung der beobachteten Anlage bzw. wenigstens eines Aktors der Anlage. Bevorzugt werden die logischen Zustandsgrößen, die aus den Informationssignalen abgeleitet sind und auch als logische Zustandsgrößen "der jeweiligen Komponente" bezeichnet werden, mit den logischen Zustandsgrößen von der Messeinrichtung logisch verknüpft, insbesondere im Rahmen der Sicherheitsauswertung. Auf diese Weise kann mit geringem Aufwand eine Sicherheitsfunktion realisiert werden, welche von dem Zustand des Sicherheitssensors und dem Zustand der weiteren Komponente abhängt. Der Sicherheitssensor und die wenigstens eine weitere Komponente können Teil eines Sicherheitssystems sein. Da die speicherprogrammierbare Steuerung in den Sicherheitssensor integriert ist, kann auch dann die von den Informationssignalen der Messeinrichtung und den weiteren Komponenten abhängige Steuerung der beobachteten Anlage realisiert werden, ohne dass eine separate Sicherheitssteuerung notwendig ist.

Gemäß einer vorteilhaften Ausführungsform ist die wenigstens eine Komponente ein interner, d.h. in den Sicherheitssensor integrierter, oder externer Signalgeber. Die Auswerteeinheit kann dementsprechend wenigstens einen Signaleingang zum Empfangen von Informationssignalen wenigstens eines externen Signalgebers umfassen und/oder zum Empfangen von Informationssignalen wenigstens eines in den Sicherheitssensor integrierten Signalgebers ausgebildet sein.

Bei dem Signalgeber kann es sich zum Beispiel um ein Schutzgerät, um einen Encoder, um einen Drehgeber, um einen Positionsschalter, um einen Endschalter, um einen Schlüsselschalter oder um eine Bedieneinheit für einen Benutzer handeln.

Die Bedieneinheit kann zum Beispiel eine Bedienereingabe zur Überwindung einer Wiederanlaufsperre und/oder zur Einstellung eines Schutzfelds des Sicherheitssensors ermöglichen. Die Auswerteeinheit ist dazu eingerichtet, die Bedienereingaben auszuwerten, um abhängig davon eine Wiederanlaufsperre zu überwinden, das heißt eine nach einer Sicherheitsmaßnahme wie zum Beispiel der Abschaltung einer Maschine der Anlage automatisch durchgeführte und ein Wiedereinschalten der Maschine verhindernde Sperrung zu beseitigen, oder um ein Schutzfeld des Sicherheitssensors abhängig von der Bedienereingabe einzustellen. Die Sperrung kann von dem Sicherheitssensor als Teil der Sicherheitsfunktion durchgeführt werden.

Wie vorstehend beschrieben, kann es sich bei dem Signalgeber um ein, insbesondere externes, Schutzgerät handeln. Das Informationssignal kann ein von dem Schutzgerät erzeugtes Sicherheitssignal sein. Das Sicherheitssignal repräsentiert vorzugsweise einen sicheren oder nicht sicheren Zustand des Schutzgeräts, wobei sich die Begriffe "sicher" und "nicht sicher" darauf beziehen, ob von dem Schutzgerät ein für eine Person möglicherweise sicherheitsgefährdender Zustand festgestellt wird oder nicht. Das externe Schutzgerät kann dieselbe Anlage beobachten wie der optoelektronische Sicherheitssensor bzw. dieselbe oder eine andere Maschine der Anlage. Die von dem Sicherheitssensor durchgeführte Sicherheitsauswertung kann eine logische Auswertung der logischen Zustandsgrößen umfassen, die von den Informationssignalen des externen Schutzgeräts abgeleitet sind.

Bei dem Schutzgerät kann es sich zum Beispiel um einen Not-Aus-Taster, ein Lichtgitter, einen Laserscanner, eine Zuhaltung für eine Schutztür, einen Sicherheitsschalter oder ein ähnliches Schutzgerät handeln. Bei dem Sicherheitssignal kann es sich zum Beispiel um ein Testsignal oder um ein OSSD-Signal handeln, welches vorzugsweise über eine dem externen Schutzgerät zugeordnete Leitung von dem externen Schutzgerät zu dem Sicherheitssensor übertragen wird. Das Sicherheitssignal kann auch über einen, bevorzugt sicheren, Feldbus an den Sicherheitssensor übertragen werden, an dem neben dem Sicherheitssensor eines oder mehrere externe Schutzgeräte angebunden sein können.

Die Auswerteeinheit kann einen, insbesondere sicheren, Eingang aufweisen, an dem die Sicherheitssignale von dem externen Schutzgerät empfangen werden. Ein sicherer Eingang zeichnet sich durch eine fehlersichere Auswertung der eingehenden Signale aus und kann zum Beispiel durch eine redundante Auswertung realisiert sein, welche z.B. durch zwei einander überwachende Mikroprozessoren durchgeführt werden kann. Ein sicherer Eingang kann die Signale von genau einem externen Schutzgerät oder, insbesondere bei Verwendung eines Feldbusses, von mehreren externen Schutzgeräten empfangen.

Gemäß einer weiteren Ausführungsform ist die wenigstens eine Komponente ein Prozessdaten-Netzwerk, das zur Übertragung von Prozessdaten eingerichtet ist, die einen durch den Sicherheitssensor beobachteten Prozess betreffen, in den die von dem Sicherheitssensor beobachtete Anlage vorzugsweise eingebunden ist. Der Sicherheitssensor kann dabei eine Sicherheitsfunktion realisieren, die die von dem Prozessdaten-Netzwerk übertragenen Prozessdaten berücksichtigt.

Der Sicherheitssensor kann zum Empfangen und Auswerten von Informationssignalen von mehreren und insbesondere allen vorstehend beschriebenen Typen von weiteren Komponenten, d.h. internen oder externen Signalgebern oder Prozessdaten-Netzwerken, eingerichtet sein. Von den Informationssignalen abgeleitete logische Zustandsgrößen können von der speicherprogrammierbaren Steuerung, insbesondere als Teil der Sicherheitsauswertung, logisch ausgewertet und vorzugsweise mit den logischen Zustandsgrößen von der Messeinrichtung und/oder mit den logischen Zustandsgrößen von einer anderen weiteren Komponente, insbesondere von einem anderen Komponenten-Typ, logisch verknüpft werden.

Mit dem in dieser Weise eingerichteten Sicherheitssensor lassen sich mit geringem Aufwand komplexe Sicherheitssysteme realisieren, welche neben dem optoelektronischen Sicherheitssensor eine oder mehrere weitere Komponenten wie z.B. eines oder mehrere, insbesondere externe, Schutzgeräte umfassen und es lässt sich eine den Zustand dieser weiteren Komponenten berücksichtigende Steuer- bzw. Sicherheitsfunktion realisieren. Beispielsweise können die logischen Zustandsgrößen von der Messeinrichtung und von wenigstens einer weiteren Komponente im Rahmen einer für eine aktive Steuerung der Anlage durchgeführten Sicherheitsauswertung verknüpft werden. Die Zustandsgrößen können auch so verknüpft werden, dass eine Abschaltung einer Maschine der beobachteten Anlage erfolgt, wenn der Sicherheitssensor oder das Schutzgerät einen nicht sicheren Zustand anzeigt.

Gemäß einer vorteilhaften Ausführungsform ist der Sicherheitssensor dazu eingerichtet, ein einstellbares Schutzfeld zu überwachen, wobei die in den Sicherheitssensor integrierte speicherprogrammierbare Steuerung dazu eingerichtet ist, das einzustellende Schutzfeld durch eine logische Auswertung zu bestimmen.

Das einzustellende Schutzfeld kann von der speicherprogrammierbaren Steuerung abhängig von logischen Zustandsgrößen von der Messeinrichtung und/oder, sofern vorhanden, abhängig von logischen Zustandsgrößen von einer oder mehreren weiteren Komponenten bestimmt werden, welche wenigstens einen internen oder externen Signalgeber wie z.B. ein externes Schutzgerät und/oder wenigstens ein Prozessdaten-Netzwerk umfassen können, wobei die logischen Zustandsgrößen von verschiedenen Geräten (Sicherheitssensor, weitere Komponenten) logisch miteinander verknüpft werden können. Dadurch kann mit geringem Aufwand eine einer gewünschten Funktion des Sicherheitssensors entsprechende Einstellung des Schutzfelds erreicht werden. Beispielsweise kann die Schutzfeldeinstellung zumindest von den logischen Zustandsgrößen von einem externen oder internen Signalgeber, insbesondere einem Positionsschalter oder Schlüsselschalter, oder von den logischen Zustandsgrößen von dem Prozessdaten-Netzwerk oder von einer logischen Verknüpfung der logischen Zustandsgrößen des externen oder internen Signalgebers und des Prozessdaten-Netzwerks abhängen.

Die speicherprogrammierbare Steuerung kann dazu eingerichtet sein, ein, insbesondere binär codiertes, Steuersignal an das Applikationsmodul bereitzustellen, welches das einzustellende Schutzfeld identifiziert. Das Applikationsmodul kann dazu eingerichtet sein, den Sicherheitsbereich in der eingangs beschriebenen Weise gemäß dem identifizierten Schutzfeld zu überwachen.

Gemäß einer Ausführungsform ist die Auswerteeinheit dazu eingerichtet, abhängig von einer durch die speicherprogrammierbare Steuerung durchgeführten logischen Auswertung ein Informationssignal zu erzeugen und an ein Prozessdaten-Netzwerk zu senden, welches zur Übertragung von Prozessdaten eingerichtet ist, die einen durch den Sicherheitssensor beobachteten Prozess betreffen. Der Sicherheitssensor und das Prozessdaten-Netzwerk können Teil eines Sicherheitssystems sein. Die von dem Sicherheitssensor übertragenen Informationen können zum Beispiel eine Information über ein an dem Sicherheitssensor eingestelltes Schutzfeld oder über einen Diagnosestatus des Sicherheitssensors umfassen.

Der Sicherheitssensor kann eine Netzwerkschnittstelle zur Verbindung mit einem Prozessdaten-Netzwerk und insbesondere zur Anbindung an eine Busleitung des Prozessdaten-Netzwerks aufweisen. Alternativ oder zusätzlich zu einer Netzwerkschnittstelle kann der Sicherheitssensor einen Diagnoseausgang zur Ausgabe von Informationssignalen aufweisen, die einen Diagnosestatus des Sicherheitssensors repräsentieren.

Bei der speicherprogrammierbaren Steuerung kann es sich um eine sichere speicherprogrammierbare Steuerung handeln. Eine solche Steuerung zeichnet sich durch eine fehlersichere Auswertung aus, welche zum Beispiel durch eine redundante Auswertung erreicht werden kann.

Die Messeinrichtung und die Auswerteeinheit sind vorzugsweise in einem gemeinsamen Gehäuse des Sicherheitssensors untergebracht, welches vorzugsweise gemäß der Gehäuseschutzart IP 67 ausgebildet ist.

Weiterer Gegenstand der Erfindung ist ein Sicherheitssystem mit wenigstens einem erfindungsgemäßen optoelektronischen Sicherheitssensor gemäß der vorliegenden Beschreibung. Die in der vorliegenden Beschreibung in Bezug auf den Sicherheitssensor sowie dessen Einbindung bzw. Verwendung in einem Sicherheitssystem beschriebenen Vorteile und vorteilhaften Ausführungsformen stellen entsprechende Vorteile und vorteilhafte Ausführungsformen des Sicherheitssystems dar. Wie vorstehend beschrieben, kann der Sicherheitssensor z.B. ohne separate Sicherheitssteuerung direkt mit einem Aktor der Anlage wie z.B. einem sicheren Antrieb verbunden sein und dazu ausgebildet sein, diesen in Abhängigkeit von der logischen Auswertung zu steuern, die von der in den Sicherheitssensor integrierten speicherprogrammierbaren Steuerung durchgeführt wird.

Nachfolgend wird die Erfindung beispielhaft vorteilhafter Ausführungsformen unter Bezugnahme auf die beigefügten Figuren beschrieben. Es zeigen:
- Fig. 1: einen optoelektronischen Sicherheitssensor gemäß einer Ausführungsform der Erfindung in einer schematischen Darstellung, und
- Fig. 2: ein den in Fig. 1 gezeigten Sicherheitssensor umfassendes Sicherheitssystem gemäß einer Ausführungsform der Erfindung in einer schematischen Darstellung.

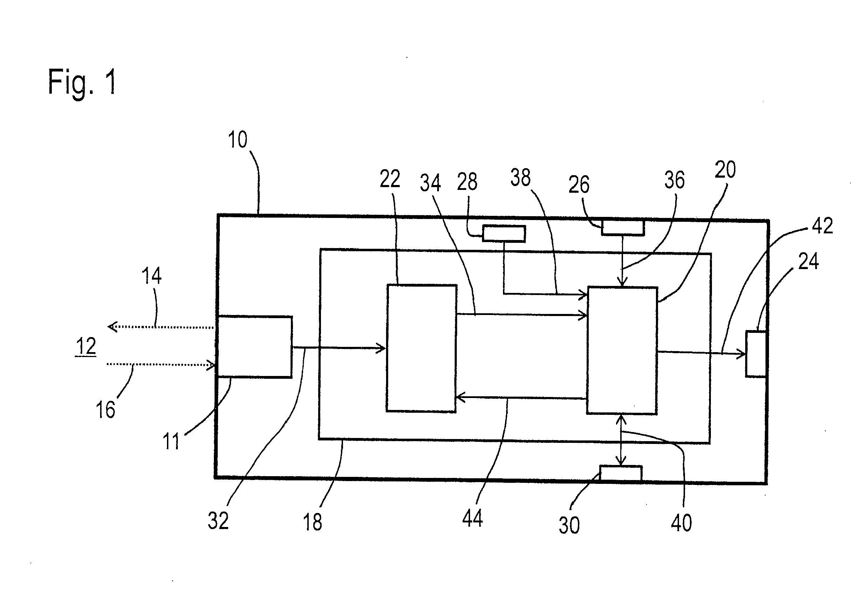

Der in Fig. 1 gezeigte Sicherheitssensor 10 umfasst eine optoelektronische Messeinrichtung 11, die dazu eingerichtet ist, die in Fig. 1 durch einen gestrichelten Pfeil dargestellte elektromagnetische Strahlung 14 in einen Sicherheitsbereich 12 auszusenden, und dazu, ebenfalls durch einen gestrichelten Pfeil dargestellte, aus dem Sicherheitsbereich 12 zurückkehrende Strahlung 16 zu empfangen und daraus Empfangssignale zu generieren, die von der Intensität der zurückkehrenden Strahlung 16 abhängen, wobei der Begriff "Intensität" auch das Vorhandensein oder NichtVorhandensein zurückkehrender Strahlung 16 umfasst. Die Messeinrichtung 11 könnte auch durch einen Kamerasensor gebildet sein. In diesem Fall kann auf die Aussendung von Sendestrahlung 14 verzichtet werden und der Kamerasensor kann die bereits vorhandene Strahlung empfangen, die aus dem Sicherheitsbereich 12 auf die Messeinrichtung 11 trifft.

Die Empfangssignale werden von der Messeinrichtung 11 über die Verbindung 32 einer elektronischen Auswerteeinheit 18 bereitgestellt. Ein Applikationsmodul 22 ermittelt aus den Empfangssignalen abhängig von einem an dem Applikationsmodul 22 eingestellten Schutzfeld logische Zustandsgrößen, welche im vorliegenden Ausführungsbeispiel einen sicheren oder nicht sicheren Zustand des Sicherheitsbereichs 12 repräsentieren. Die logischen Zustandsgrößen werden von dem Applikationsmodul 22 über die Verbindung 34 einer speicherprogrammierbaren Steuerung 20 der Auswerteeinheit 18 bereitgestellt.

Die Auswerteeinheit 18 ist außerdem dazu eingerichtet, logische Zustandsgrößen aus Informationssignalen abzuleiten, die an einem sicheren Eingang 26 von einem externen Schutzgerät empfangbar sind, und diese über die Verbindung 36 der speicherprogrammierbaren Steuerung 20 zur Verfügung zu stellen. Ferner werden von einem z.B. als Schlüsselschalter ausgebildeten internen Signalgeber 28 des Sicherheitssensors 10 erzeugte Informationssignale von der Auswerteeinheit 18 empfangen, welche aus den Informationssignalen logische Zustandsgrößen ableitet und diese der speicherprogrammierbaren Steuerung 20 über die Verbindung 38 zur Verfügung stellt. Über eine Netzwerkschnittstelle 30 sind außerdem Prozessdaten von einem Prozessdaten-Netzwerk empfangbar, aus denen von der Auswerteeinheit 18 logische Zustandsgrößen abgeleitet und der speicherprogrammierbaren Steuerung 20 über die Verbindung 40 zur Verfügung gestellt werden.

Die speicherprogrammierbare Steuerung 20 ist dazu eingerichtet, die logischen Zustandsgrößen von dem Applikationsmodul 22, von dem sicheren Eingang 26, von dem internen Signalgeber 28 und von der Netzwerkschnittstelle 30 logisch auszuwerten und logisch miteinander zu verknüpfen. Abhängig von der logischen Auswertung erzeugt die Auswerteeinheit 18 ein als OSSD-Signal ausgebildetes Steuersignal, welches über die Verbindung 42 dem OSSD-Ausgang 24 zur Verfügung gestellt wird und dort zum Beispiel an ein Sicherheitsrelais zur Abschaltung einer Maschine ausgebbar ist. Zusätzlich kann auch ein in Fig. 1 nicht dargestellter weiterer Signalausgang zur aktiven Steuerung einer von dem Sicherheitssensor 10 beobachteten Anlage vorgesehen sein.

Die logische Auswertung in der speicherprogrammierbaren Steuerung 20 umfasst außerdem die Auswahl des von dem Sicherheitssensor 10 zu überwachenden Schutzfelds. Die speicherprogrammierbare Steuerung 20 erzeugt ein Steuersignal, welches das einzustellende Schutzfeld identifiziert und welches dem Applikationsmodul 22 über die Verbindung 44 zur Verfügung gestellt wird. Das Applikationsmodul 22 empfängt dieses Steuersignal und stellt das jeweilige Schutzfeld ein. Die Einstellung des Schutzfelds kann durch eine entsprechende Auswertung in dem Applikationsmodul 22 erfolgen, zum Beispiel indem eine entsprechende Auswahl der empfangenen Empfangssignale für die Erzeugung der logischen Zustandsgrößen herangezogen werden. Die Einstellung des Schutzfelds kann auch eine entsprechende Änderung der von der Messeinrichtung 11 durchgeführten Messvorgänge umfassen, wobei das Applikationsmodul 22 die Messeinrichtung 11 über die in diesem Fall als bidrektionale Verbindung ausgestaltete Verbindung 32 entsprechend ansteuert.

Die Auswerteeinheit 18 erzeugt außerdem abhängig von der durch die speicherprogrammierbare Steuerung 20 durchgeführten logischen Auswertung Informationssignale, welche zum Beispiel eine Information über ein aktuell eingestelltes Schutzfeld oder einen Diagnosestatus des Sicherheitssensors 10 repräsentieren, und stellt die entsprechenden Informationssignale über die Verbindung 40 an die Netzwerkschnittstelle 30 zur Ausgabe an ein gegebenenfalls vorhandenes Prozessdaten-Netzwerk bereit.

Die speicherprogrammierbare Steuerung 20 und das Applikationsmodul 22 können beide zumindest teilweise durch eine gemeinsame Verarbeitungseinheit der Auswerteeinheit 18, insbesondere einen gemeinsamen Mikroprozessor, realisiert sein.

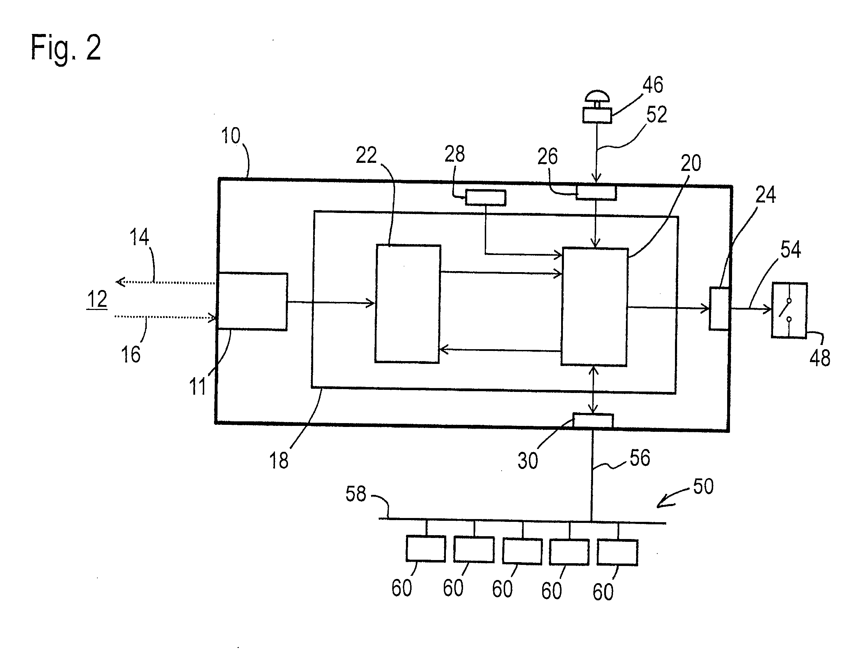

Fig. 2 zeigt ein Sicherheitssystem, welches den in Fig. 1 gezeigten optoelektronischen Sicherheitssensor 10 umfasst.

Das Sicherheitssystem umfasst ferner ein als Not-Aus-Taster ausgebildetes externes Schutzgerät 46, welches abhängig von einem betätigten oder nicht betätigten Zustand des Not-Aus-Tasters 46 ein Sicherheitssignal erzeugt und über die Verbindung 52 an den sicheren Eingang 26 liefert, welches einen sicheren oder nicht sicheren Zustand repräsentiert.

Ferner ist ein externes Sicherheitsrelais 48 vorgesehen, welches in die Stromzuführung einer Maschine der beobachteten Anlage derart eingeschaltet ist, dass die Stromzuführung durch Öffnen des Relais 48 unterbrechbar und die Maschine dadurch anhaltbar ist. Das Relais 48 ist über die Verbindung 54 mit dem OSSD-Ausgang 24 verbunden, so dass das Relais 48 durch das an dem OSSD-Ausgang 24 bereitgestellte OSSD-Signal zum Öffnen und Schließen ansteuerbar ist. Zusätzlich zu dem Relais 48 kann auch ein in Fig. 2 nicht dargestellter Aktor der von dem Sicherheitssensor 10 beobachteten Anlage vorgesehen sein, der über einen entsprechenden Signalausgang des Sicherheitssensors 10 abhängig von der in der speicherprogrammierbaren Steuerung 20 durchgeführten logischen Auswertung zur aktiven Steuerung der Anlage ansteuerbar ist.

Schließlich ist ein Prozessdaten-Netzwerk 50 vorgesehen, welches eine Vielzahl von an eine Busleitung 58 des Netzwerks 50 angeschlossenen Busteilnehmern 60 umfasst, wobei die Busleitung 58 über die Verbindung 56 derart mit der Netzwerkschnittstelle 30 verbunden ist, dass der vorstehend in Bezug auf Fig. 1 beschriebene Informationsaustausch zwischen dem Sicherheitssensor 10 und dem Netzwerk 50 ermöglicht wird.

### Bezugszeichenliste

- 10: optoelektronischer Sicherheitssensor
- 11: optoelektronische Messeinrichtung
- 12: Sicherheitsbereich
- 14: ausgesendete Strahlung
- 16: zurückkehrende Strahlung
- 18: Auswerteeinheit
- 20: speicherprogrammierbare Steuerung
- 22: Applikationsmodul
- 24: OSSD-Ausgang
- 26: sicherer Eingang
- 28: interner Signalgeber
- 30: Netzwerkschnittstelle
- 32, 34: Verbindung
- 36, 38: Verbindung
- 40, 42, 44: Verbindung
- 46: Schutzgerät
- 48: Sicherheitsrelais
- 50: Prozessdaten-Netzwerk
- 52, 54, 56: Verbindung
- 58: Busleitung
- 60: Busteilnehmer

## Patentansprüche

1. Optoelektronischer Sicherheitssensor (10), vorzugsweise ein Laserscanner, ein Lichtgitter oder eine Kamera, umfassend
- eine optoelektronische Messeinrichtung (11) zum Erzeugen von Messsignalen, die von einem Zustand eines von dem Sicherheitssensor (10) beobachteten Sicherheitsbereichs (12) abhängen, und
- eine elektronische Auswerteeinheit (18) zur Auswertung der Messsignale,
**dadurch gekennzeichnet, dass** die elektronische Auswerteeinheit (18) eine in den optoelektronischen Sicherheitssensor (10) integrierte speicherprogrammierbare Steuerung (20) zur logischen Auswertung von logischen Zustandsgrößen umfasst, die aus den Messsignalen abgeleitet sind.

2. Vorrichtung nach Anspruch 1,
**dadurch gekennzeichnet, dass** die speicherprogrammierbare Steuerung (20) eine speicherprogrammierbare Steuerung in Software bzw. Soft-SPS ist.

3. Vorrichtung nach Anspruch 1 oder 2,
**dadurch gekennzeichnet, dass** die Auswerteeinheit (18) ein Applikationsmodul (22) aufweist, welches dazu eingerichtet ist, aus den Messsignalen oder davon abgeleiteten Messgrößen die logischen Zustandsgrößen zu erzeugen.

4. Vorrichtung nach Anspruch 3,
**dadurch gekennzeichnet, dass** die speicherprogrammierbare Steuerung (20) und das Applikationsmodul (22) zumindest teilweise und vorzugsweise vollständig durch eine gemeinsame Verarbeitungseinheit gebildet sind, welche vorzugsweise einen gemeinsamen Mikroprozessor umfasst.

5. Vorrichtung nach zumindest einem der vorstehenden Ansprüche,
**dadurch gekennzeichnet, dass** die Auswerteeinheit (18) dazu eingerichtet ist, abhängig von einer Sicherheitsauswertung, die eine durch die speicherprogrammierbare Steuerung (20) durchgeführte logische Auswertung umfasst, eine Steuermaßnahme zu ergreifen, vorzugsweise zur Steuerung zumindest eines Aktors einer von dem Sicherheitssensor beobachteten Anlage.

6. Vorrichtung nach Anspruch 5,
**dadurch gekennzeichnet, dass** die Steuermaßnahme das Erzeugen eines Steuersignals durch die Auswerteeinheit (18) umfasst.

7. Vorrichtung nach zumindest einem der vorstehenden Ansprüche,
**dadurch gekennzeichnet, dass** die Auswerteeinheit (18) dazu eingerichtet ist, Informationssignale von wenigstens einer weiteren Komponente (28, 46, 50) zu empfangen und auszuwerten, wobei die Auswertung vorzugsweise eine logisehe Auswertung von logischen Zustandsgrößen, die aus den Informationssignalen abgeleitet sind, durch die speicherprogrammierbare Steuerung (20) umfasst.

8. Vorrichtung nach Anspruch 7,
**dadurch gekennzeichnet, dass** die wenigstens eine Komponente ein interner oder externer Signalgeber (28, 46) ist.

9. Vorrichtung nach Anspruch 7 oder 8,
**dadurch gekennzeichnet, dass** die wenigstens eine Komponente ein Prozessdaten-Netzwerk (50) ist, das zur Übertragung von Prozessdaten eingerichtet ist, die einen durch den Sicherheitssensor (10) beobachteten Prozess betreffen.

10. Vorrichtung nach zumindest einem der vorstehenden Ansprüche,
**dadurch gekennzeichnet, dass** der Sicherheitssensor (10) dazu eingerichtet ist, ein einstellbares Schutzfeld zu beobachten, und dass die speicherprogrammierbare Steuerung (20) dazu eingerichtet ist, das einzustellende Schutzfeld durch eine logische Auswertung zu bestimmen.

11. Vorrichtung nach zumindest einem der vorstehenden Ansprüche,
**dadurch gekennzeichnet, dass** die Auswerteeinheit (18) dazu eingerichtet ist, abhängig von einer durch die speicherprogrammierbare Steuerung (20) durchgeführten logischen Auswertung ein Informationssignal zu erzeugen und an ein Prozessdaten-Netzwerk (50) zu senden, welches zur Übertragung von Prozessdaten eingerichtet ist, die einen durch den Sicherheitssensor (10) beobachteten Prozess betreffen.

12. Vorrichtung nach zumindest einem der vorstehenden Ansprüche,
**dadurch gekennzeichnet, dass** die speicherprogrammierbare Steuerung (20) eine sichere speicherprogrammierbare Steuerung ist.

13. Sicherheitssystem mit wenigstens einem optoelektronischen Sicherheitssensor (10) gemäß einem der vorstehenden Ansprüche.

## Geänderte Patentansprüche

### Geänderte Patentansprüche gemäss Regel 137(2) EPÜ.

1. Optoelektronischer Sicherheitssensor (10), vorzugsweise ein Laserscanner, ein Lichtgitter oder eine Kamera, umfassend
- eine optoelektronische Messeinrichtung (11) zum Erzeugen von Messsignalen, die von einem Zustand eines von dem Sicherheitssensor (10) beobachteten Sicherheitsbereichs (12) abhängen, und
- eine elektronische Auswerteeinheit (18) zur Auswertung der
Messsignale,
wobei,
die elektronische Auswerteeinheit (18) eine in den optoelektronischen Sicherheitssensor (10) integrierte speicherprogrammierbare Steuerung (20) zur logischen Auswertung von logischen Zustandsgrößen umfasst, die aus den Messsignalen abgeleitet sind, **dadurch gekennzeichnet, dass** der Sicherheitssensor (10) dazu eingerichtet ist, ein einstellbares Schutzfeld zu beobachten, und dass die speicherprogrammierbare Steuerung (20) dazu eingerichtet ist, das einzustellende Schutzfeld durch eine logische Auswertung zu bestimmen.

2. Vorrichtung nach Anspruch 1,
**dadurch gekennzeichnet, dass** die speicherprogrammierbare Steuerung (20) eine speicherprogrammierbare Steuerung in Software bzw. Soft-SPS ist.

3. Vorrichtung nach Anspruch 1 oder 2,
**dadurch gekennzeichnet, dass** die Auswerteeinheit (18) ein Applikationsmodul (22) aufweist, welches dazu eingerichtet ist, aus den Messsignalen oder davon abgeleiteten Messgrößen die logischen Zustandsgrößen zu erzeugen.

4. Vorrichtung nach Anspruch 3,
**dadurch gekennzeichnett, dass** die speicherprogrammierbare Steuerung (20) und das Applikationsmodul (22) zumindest teilweise und vorzugsweise vollständig durch eine gemeinsame Verarbeitungseinheit gebildet sind, welche vorzugsweise einen gemeinsamen Mikroprozessor umfasst.

5. Vorrichtung nach zumindest einem der vorstehenden Ansprüche, **dadurch gekennzeichnet, dass** die Auswerteeinheit (18) dazu eingerichtet ist, abhängig von einer Sicherheitsauswertung, die eine durch die speicherprogrammierbare Steuerung (20) durchgeführte logische Auswertung umfasst, eine Steuermaßnahme zu ergreifen, vorzugsweise zur Steuerung zumindest eines Aktors einer von dem Sicherheitssensor beobachteten Anlage.

6. Vorrichtung nach Anspruch 5,
dadurch **gekennzeichnett, dass** die Steuermaßnahme das Erzeugen eines Steuersignals durch die Auswerteeinheit (18) umfasst.

7. Vorrichtung nach zumindest einem der vorstehenden Ansprüche, dadurch **gekennzeichnett, dass** die Auswerteeinheit (18) dazu eingerichtet ist, Informationssignale von wenigstens einer weiteren Komponente (28, 46, 50) zu empfangen und auszuwerten, wobei die Auswertung vorzugsweise eine logische Auswertung von logischen Zustandsgrößen, die aus den Informationssignalen abgeleitet sind, durch die speicherprogrammierbare Steuerung (20) umfasst.

8. Vorrichtung nach Anspruch 7,
dadurch **gekennzeichnet,** dass die wenigstens eine Komponente ein interner oder externer Signalgeber (28, 46) ist.

9. Vorrichtung nach Anspruch 7 oder 8,
**dadurch gekennzeichnet, dass** die wenigstens eine Komponente ein Prozessdaten-Netzwerk (50) ist, das zur Übertragung von Prozessdaten eingerichtet ist, die einen durch den Sicherheitssensor (10) beobachteten Prozess betreffen.

10. Vorrichtung nach zumindest einem der vorstehenden Ansprüche, dadurch **gekennzeichnet,** dass die Auswerteeinheit (18) dazu eingerichtet ist, abhängig von einer durch die speicherprogrammierbare Steuerung (20) durchgeführten logischen Auswertung ein Informationssignal zu erzeugen und an ein Prozessdaten-Netzwerk (50) zu senden, welches zur Übertragung von Prozessdaten eingerichtet ist, die einen durch den Sicherheitssensor (10) beobachteten Prozess betreffen.

11. Vorrichtung nach zumindest einem der vorstehenden Ansprüche, **dadurch gekennzeichnet, dass** die speicherprogrammierbare Steuerung (20) eine sichere speicherprogrammierbare Steuerung ist.

12. Sicherheitssystem mit wenigstens einem optoelektronischen Sicherheitssensor (10) gemäß einem der vorstehenden Ansprüche.
